Europäisches Patentamt

European Patent Office

Office européen des brevets

(19)

(11) **EP 1 146 651 A1**

(12) ## EUROPEAN PATENT APPLICATION

(43) Date of publication:
**17.10.2001 Bulletin 2001/42**

(51) Int Cl.⁷: **H03M 13/09**, H03M 13/00, H03M 13/15, G11B 20/18

(21) Application number: **01303265.1**

(22) Date of filing: **06.04.2001**

(84) Designated Contracting States:
**AT BE CH CY DE DK ES FI FR GB GR IE IT LI LU MC NL PT SE TR**
Designated Extension States:
**AL LT LV MK RO SI**

(30) Priority: **10.04.2000 EP 00303023**

(71) Applicant: **Hewlett-Packard Company**
**Palo Alto, CA 94304 (US)**

(72) Inventor: **Paterson, Kenneth Graham**
**Cotham, Bristol BS6 5TP (GB)**

(74) Representative:
**Lawman, Matthew John Mitchell et al**
**Hewlett-Packard Limited,**
**IP Section,**
**Building 3,**
**Filton Road**
**Stoke Gifford, Bristol BS34 8QZ (GB)**

(54) **Error detection for data storage and transmission**

(57)     A method of decoding C1, C2 encoded data in a digital data storage (DDS) format device comprises performing C1, C2 error correction; applying a check sum to a result of said C1, C2 error correction; if errors are detected after C1, C2 correction, applying C3 correction; applying a check sum to a result of said C3 correction, wherein said check sum is determined by applying a polynomial remaindering process wherein the polynomial is primitive over $GF(2^8)$ and wherein the polynomial has roots that are different from the roots of a generator polynomial of a Reed-Solomon code, said process being applied to bytes of user data in a byte wise manner.

Output

C 1102     B 1101     A 1100     I/P

1103

·α on a

a = a7, a6, a5, a4, a3, a2, a1, a0

a' = a6, a5, a4, a3, a2, a1, a0, O

If a7 = 1  then a'= a' XOR 00011101

Output = a'

Fig. 11

EP 1 146 651 A1

## Description

## Field of the Invention

The present invention relates to the field of data handling, especially data transmission and data storage, and particularly, to a method and apparatus for detection of errors in sets of data.

## Background to the Invention

Conventional digital data storage (DDS) format devices provide reliable storage and retrieval of large amounts of digital data. Such devices are defined in ISO/IEEC Standard 10777:1991E.

In a DDS read/write mechanism, as defined in the ISO/IEEC Standard 10777:1991E, data is recorded on an elongate tape data storage medium coated with a magnetic coating. A rotating drum carries a plurality of read heads and a plurality of write heads. The elongate band of magnetic tape is passed around the rotating drum, resulting in a plurality of physical data tracks written in parallel across the elongate band of magnetic tape between opposite edges of the tape.

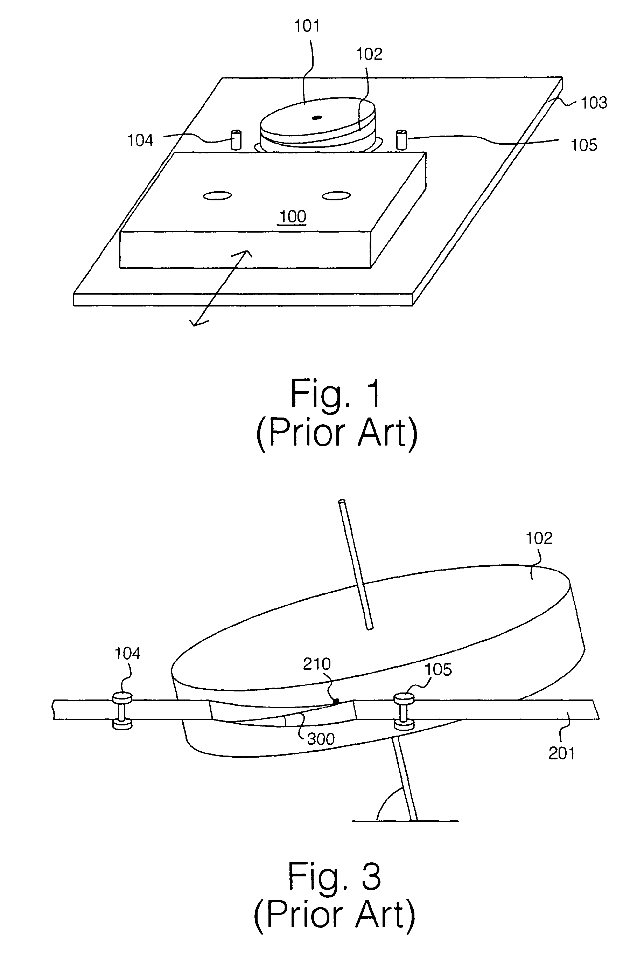

Referring to Fig. 1 herein, there is shown schematically a layout of a tape data storage cartridge in relation to a tape drive mechanism according to the known DDS - 1 to DDS - 4 formats, in which an elongate band of tape is contained within a removable tape cartridge 100. The tape cartridge is inserted between a pair of guides of a tape drive mechanism to locate the cartridge in the mechanism. A rotating read/write head 101 comprises first and second read heads and first and second write heads situated at substantially equidistant points around a circumference of the rotating head. The head rotates on top of a substantially cylindrical metallic plinth 102. A main central axis of a cylinder formed by the outer surfaces of the drum and the plinth is directed offset from a line normal to a plane of a base plate 103, so that the effect is that as the band of tape traverses around part of the circumference of the cylindrical head plinth, the rotating heads describe a path diagonally across a width of the tape in successive passes of the heads past the tape. The read/write head rotates at a speed of approximately 11,400 revs per minute.

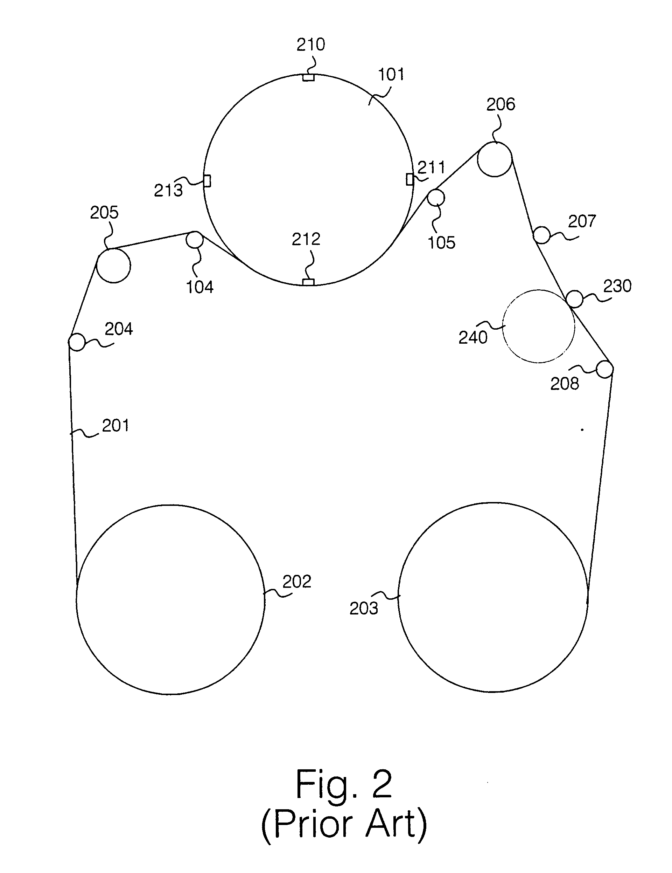

Referring to Fig. 2 herein there is shown schematically a tape path of the elongate magnetic tape data storage medium 201 as it is drawn past the rotating drum containing the read and write heads. The tape data storage medium 201 is wound onto a feed reel 202 and a take up reel 203 which are within the removable tape cartridge 100. During normal operation, the magnetic tape 201 is wound from the feed-reel 202 on to the take-up reel 203. The path of the magnetic tape 201 is constrained by a plurality of rollers and tape guides 204-208. Additional tape guides 104, 105 determine the relative positions of the rotating drum 101, the read and write heads 210-213 and the tape data storage medium 201. The feed reel 202 and tape up reel 203 are driven by electric motors to maintain a correct tension in the magnetic tape 201 past the head.

Referring to Fig, 3 herein, there is illustrated schematically the orientation of the magnetic tape 201 with respect to the rotating drum 202. The tape 201 is drawn past the rotating head at a relatively slow tape speed of the order of a few centimeters per second. However, the rotating drum 101 on which the read and write heads are mounted, typically rotates at a few thousand revolutions per minute, so the relative speed of the read and write heads to the drum is of magnitudes of order greater than the absolute tape speed. During a write operation, the write heads record a sequence of tracks diagonally across the elongate magnetic tape 201. The width of such tracks is typically of the order of 6.8 µm. A plurality of data stripes 300 are written in parallel to each other across the width of the tape by the rotating write heads. In a read operation, the read heads trace along the plurality of stripes to read individual physical tracks.

The prior art formats DDS-1, DDS-2 and DDS-3 used an exclusive (XOR) based check sum. However, this was ineffective because a C2 mis-correction will often always give the same XOR based check sum as correct data.

The prior art DDS-4 format used a more effective arithmetic sum. However, this arithmetic sum has a significant chance of giving the same check sum if a mis-correction occurs.

Specific implementations according to the present invention aim to provide a new check sum which is fast, simple to implement and offers the theoretical maximum error correction detection performance which one would expect for a two byte check sum.

## Summary of the Invention

According to a first aspect of the present invention, there is provided a method of reading data coded with a Reed-Solomon error correcting code, said method characterized by comprising the steps of:

reading (600) said data; and

performing a check sum calculation (602) on said data;

wherein said check sum calculation (602) includes applying a byte based polynomial remaindering process to the bytes of said data, the polynomial used in said polynomial remaindering process being primitive over $GF(2^8)$; and

the roots of the polynomial used in said polynomial remaindering process are different to the roots of a generator polynomial of said Reed-Solomon error correcting code.

According to a second aspect of the present invention, there is provided an apparatus for reading data, said apparatus characterized by comprising:

a reader (810) for reading data; and

a check sum calculator (813) for performing a check sum calculation on the data,

wherein said check sum calculation includes applying a byte based polynomial remaindering process to the bytes of said data, wherein a polynomial used in said polynomial remaindering process is primitive over $GF(2^8)$; and

the roots of a polynomial used in said polynomial remaindering process are different to the roots of a generator polynomial of a Reed-Solomon error correcting code.

Other features of the present invention are as recited in the claims herein.

**Brief Description of the Drawings**

For a better understanding of the invention and to show how the same may be carried into effect, there will now be described by way of example only, specific embodiments, methods and processes according to the present invention with reference to the accompanying drawings in which:

Fig. 1 illustrates schematically a prior art digital data storage (DDS) format data storage cassette and read/write head;

Fig. 2 illustrates schematically a drive mechanism for passing an elongate band of magnetic tape past a rotating read/write head according to a known DDS format;

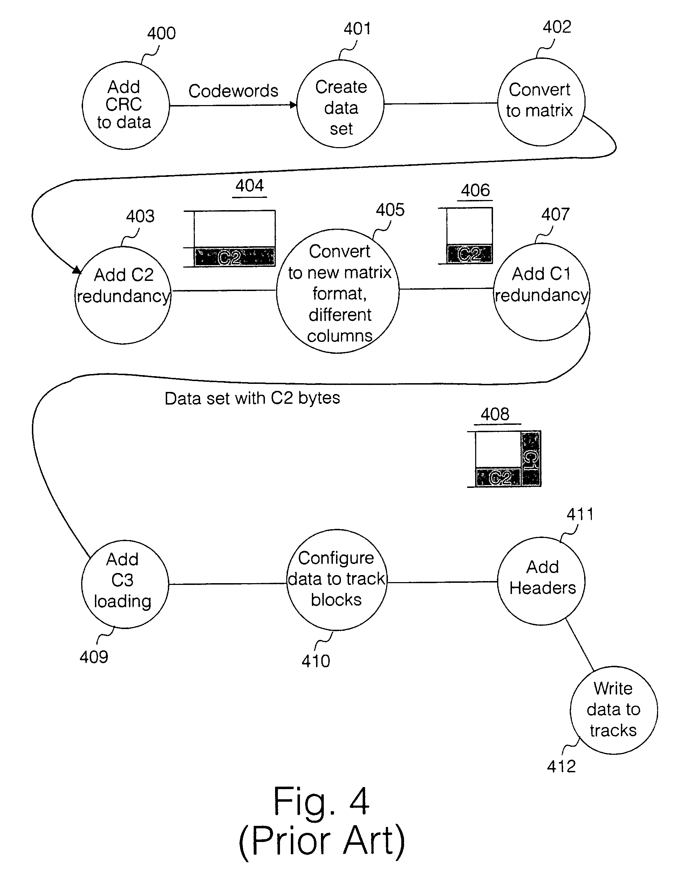

Fig. 3 illustrates schematically an orientation of a magnetic band of tape past a rotating read/write head of a known DDS format device, resulting in a plurality of written data stripes across a width of said magnetic tape;

Fig. 4 illustrates schematically a prior art redundancy coding method for C1, C2 redundancy coding data in a known DDS-4 format;

Fig. 5 illustrates schematically striping of individual tracks of data across a magnetic band of tape according to a known DDS format;

Fig. 6 illustrates schematically processes of a known decoding system including error correction according to a DDS-4 format for applying C1, C2 and C3 error correction with a single check sum step after C1 and C2 error correction;

Fig. 7 illustrates schematically a method of calculating a check sum value after C1, C2 correction according to the known DDS-4 format;

Fig. 8 illustrates schematically a write channel for encoding data and writing to tape and a read channel for reading data and decoding from a tape according to a specific implementation of the present invention;

Fig. 9 illustrates schematically a method of decoding data in the read channel of a DDS device according to the specific implementation of the present invention;

Fig. 10 illustrates schematically a data frame comprising a plurality of C1, C2 corrected user data groups, upon which C3 error correction is performed according to a specific implementation of the present invention;

Fig. 11 illustrates schematically a hardware representation for applying an algorithm for calculating a check sum value according to a specific method of the present invention;

Fig. 12 illustrates schematically process steps for calculating a check sum value according to the specific method of the present invention; and

Fig. 13 illustrates schematically an algorithm for applying a function $\cdot\alpha$ on a byte of data for calculation of the check sum value according to the specific method of the present invention.

**Detailed Description of the Best Mode for Carrying Out the Invention**

There will now be described by way of example the best mode contemplated by the inventors for carrying out the invention. In the following description numerous specific details are set forth in order to provide a thorough understanding of the present invention. It will be apparent however, to one skilled in the art, that the present invention may be practiced without limitation to these specific details. In other instances, well known methods and structures have not been described in detail so as not to unnecessarily obscure the present invention.

Referring to Fig. 4 herein, there is illustrated schematically a coding process applied to data prior to writing in a known DDS-4 format digital data storage device. In step 400, a byte stream of user data is input into a buffer. The user data is partitioned into a set of records, each having a 4 byte check sum for protecting the record. The check sum may be checked when data is recovered during a read operation of the user data when the user data is recovered from a tape data storage medium. During such a read operation, inspection of the check sum is used to verify that the user data in the record has not been corrupted during storage on the tape. In step 401, the data stream is partitioned into a plurality of data sets. Each data set is of a fixed length and is created by grouping a predetermined number of user data code words, each code word comprising a predetermined number of bytes. In step 402, each user data set is converted into a two-dimensional matrix of rows and columns. In step 403, C2 redundancy coding is added to the data matrix resulting in a C2 coded data set 404. In step 405, the C2 coded data set is converted to a new matrix format 406 having a different number of rows and columns to the first C2 coded data set 404. In step 407, C1 redundancy coding is added to the second C2 coded data set 406 resulting in a C1 and C2 coded data set 408. C1 coding is added as a plurality of extra columns to the matrix. The data in the data set is protected by two orthogonal Reed - Solomon codes (the C1 and C2 codes). Each C1 codeword consists of a plurality of bytes of processed data followed by a plurality of bytes of redundancy symbols. C1 codewords are made up of two (62, 56, 7) codewords. C2 codewords are made up from three (32, 26, 7) codewords.

The C1/C2 coded data set 408 in the known DDS-4 format data storage devices has rows 96 bytes wide, having three C2 codewords per row.

In step 409, C3 coding is added over a plurality of C1, C2 coded data sets 408. In step 410, the plurality of data sets 408, being C3 coded, are configured into track blocks, for writing on tracks of the tape data storage medium. In step 411 headers are added to the track blocks prior to writing and in step 412 the data is written to the physical tracks on tape.

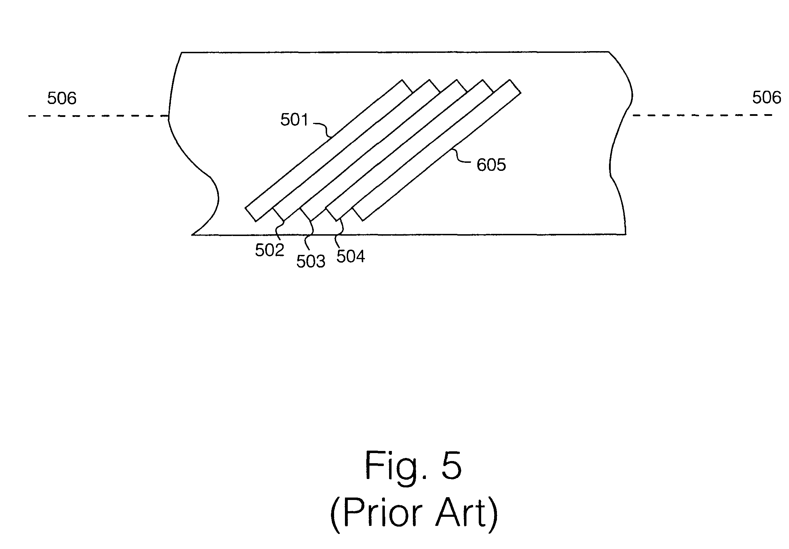

Referring to Fig. 5 herein, there is illustrated schematically a layout of physical tracks written to tape data storage medium in the DDS-4 format. Each pass of a write head across the band of tape causes a diagonally written physical track to be written across the tape. Since the head rotates at approximately 11,400 rpm, many such physical tracks arranged side by side and partially overlapping each other one on top of the other are written successively on the tape as the tape is drawn across the rotating head.

Prior art check sum algorithms, such as are known in communications systems, operate on a bit wise basis. That is to say, data streams are viewed as bit streams and data processing operations are carried out on a bit-by-bit basis, taking each individual bit one at a time. For example, calculation of a check sum may be made in a shift register of 16 bits length, where a bit stream is sequentially shifted along the shift register one bit at a time, whilst being operated on by a polynomial function. Conventional thinking is that optimum check sum algorithms operate on a bit wise basis.

However, in the DDS-3 and DDS-4 formats, check sums have been implemented on a byte wise basis. This has given a less than optimal solution in terms of error detection rates, but has been adopted due to convenience, since data is transported around devices in the DDS-3 and DDS-4 formats in quantities of bytes.

When decoding the prior art DDS-3 and DDS-4 formatted data, every once in a while, the C2 and C1 decoding fails to correct a data error or introduces a new error in which situation we refer to C1, C2 mis-correct. Data errors may be introduced at any stage of data processing prior to writing the data to the tape, or data may be corrupted during storage on the tape, or data may be incorrectly read from the tape, giving rise to errors. When errors do occur, they may be corrected by the C1 and C2 error correction algorithms.

Referring to Fig, 6 herein, there is illustrated the prior art signal processing steps for error correction in the known DDS-3 and DDS-4 formats. In step 600, C1 error correction is applied to the data read from a data storage medium. In step 601, C2 error correction is applied to the C1 error corrected data. Every once in a while, the C1 and C2 error correction fails, so that errors in the read data remain uncorrected, or new errors are introduced Such errors are detected in step 602 by a check sum calculation step. C1 and C2 error correction corrects errors within a C1, C2 coded data set. If the check sum calculations in step 603 detect that, after C1 and C2 correction, there are still errors in a data set, then C3 error correction is applied in step 604, which attempts to rectify the errors in the data set from redundancy coded data spread across other data sets in a C3 coded data set group. However, in the DDS-4 format the check sum calculations 602 may not always detect errors which have failed to be corrected by the C1 or C2 error correction or introduced by that correction process.

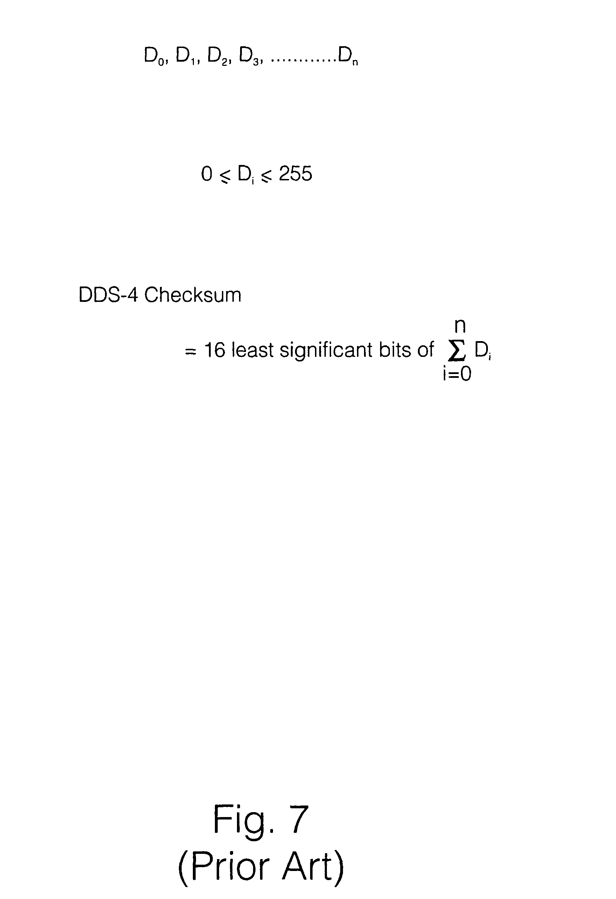

Referring to Fig. 7 herein, there is illustrated schematically application of a DDS-4 check sum to a C1, C2 error corrected user data set. The corrected user data set is treated as a sequence of bytes of data $D_0$, $D_1...D_n$, where n is approximately 6,000. Each byte $D_i$ of the data stream is interpreted as a number between 0 and 255. A DDS-4 check sum is calculated as the least significant 16 bits of the sum of all such values for each byte of the data stream. If the value gets bigger than the 65,535, then the data overflows, and the least significant 16 bits are taken as the check sum value.

Specific implementations of the present invention aim to:

- Detect a specific class of common types of error which remains uncorrected by the C1 and C2 error correction.

- Give improved performance over prior art DDS-3 and DDS-4 check sum error detection for other less common types of error which are uncorrected by C1 and C2 error corrections.

Theoretically, a well-designed check sum having 16 bits should fail only once in $2^{16}$ applications of the check sum to random data , that is to say once in every 65,536 errors. For 65,535 out of 65,536 errors, a well-designed 16 bit check sum should detect the error. However, in the DDS-4 check sum, the rate of failure to detect errors is as high as 1 in 600. In the DDS-3 format, the check sum failed with a probability of 1 (that is to say all the time) to detect common mis-correction errors introduced by the C1, C2 error correction. Using a conventional check sum, the mis-corrected user data, having already undergone C1 and C2 correction can give rise to a check sum which is the same as a check sum for a perfectly corrected user data set.

In prior art DDS-3 products, the check sum often failed, because, by coincidence, the check sum used in DDS-3 was already one of the parity checks used in C1 and C2 correction. Hence it did not detect any errors which were not already detected and corrected by the C1 and C2 error correction processes. Thus, any errors which passed through the C1 and C2 error correction without being detected by the parity checks inherent in those processes, also passed the DDS-3 check sum, because the check sum was the same as one of the parity checks in the C1, C2 processes.

In the prior art DDS-4 products, the check sum was changed from the DDS-3 check sum. However, this DDS-4 check sum gave rise to failure to detect common errors of approximately 1 in 600, with approx. 599 out of every 600 errors being detected.

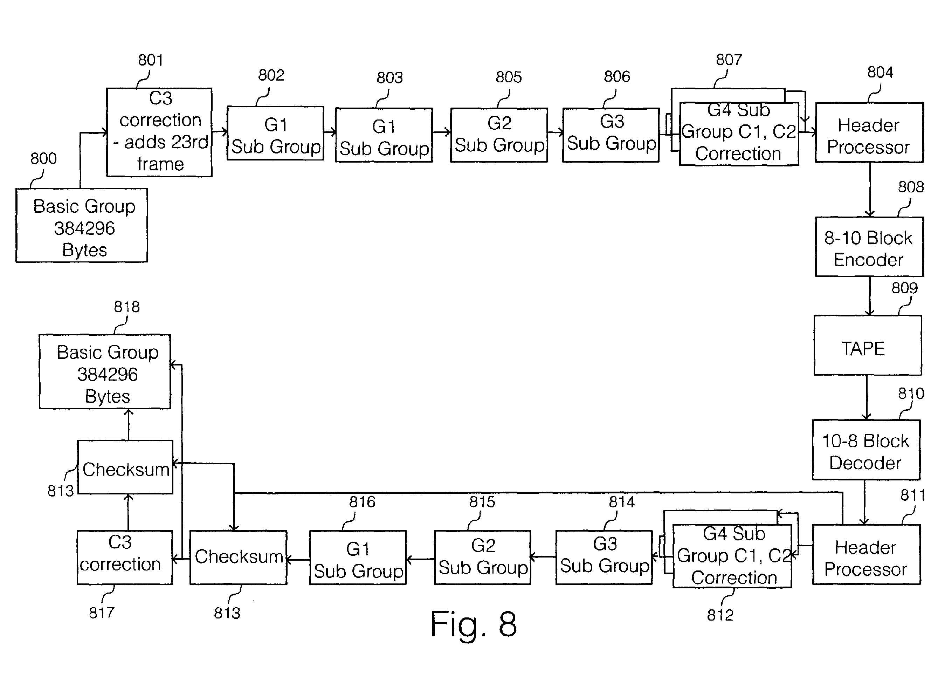

Referring to Fig. 8 in the accompanying drawings, there is illustrated schematically a write channel of a data storage device for storing data in a tape data storage means, modified to provide a check sum system in accordance with the specific implementation of the present invention. A stream of user data for storage onto the tape is grouped into a plurality of basic groups, each of 384,296 bytes by a basic group module compiler, 800. C3 correction is added to every 23$^{rd}$ frame by C3 encoder 801. A track check sum is generated by track check sum generator 802, to generate a check sum which is added to the group data. Once a basic group has been completed, it is split by a G1 sub-group processor 803 into a plurality of 22 G1 sub-groups, each having 17,468 bytes, numbered from 0 to 17, 467. Each G1 sub-group has a running number in the range of from 1 to 22. An error correction code (ECC3) processor 804 derives data from each of the 22 G1 subgroups to form a 23$^{rd}$ G1 subgroup. The error correction code C3 is a GF($2^8$) Reed-Solomon code. The error correction code C3 has the capability of correcting any two tracks which are bad in a recorded data group.

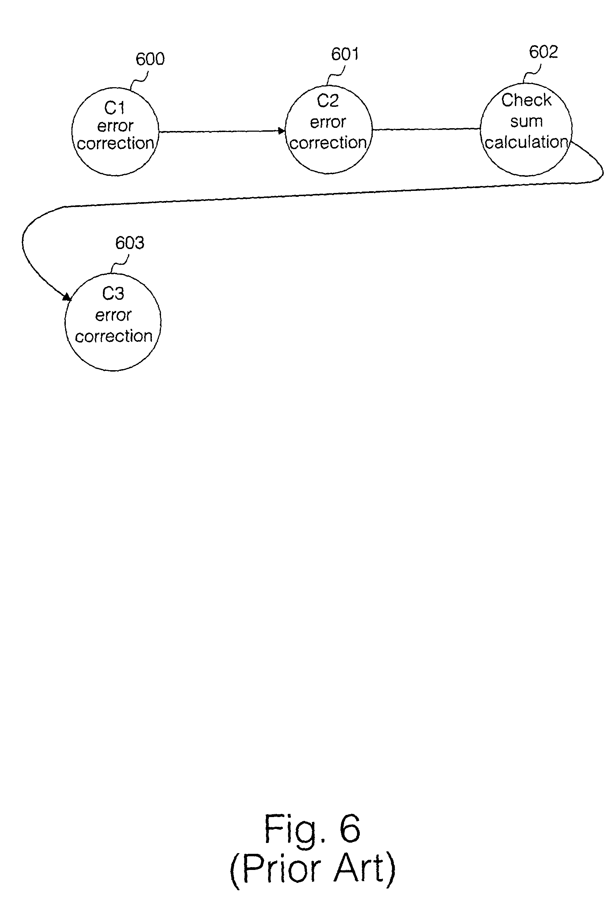

The bytes of each G1 subgroup are randomized by a G2 subgroup module 805. Byte numbering from $D_0$ to $D_{17,467}$ is retained. A G3 subgroup module 806 operates on the G2 subgroup so that each G2 subgroup of 17,468 bytes is arranged to group as $D_0$ to $D_{8733}$ over G2 subgroup in a first track (track A) of the G3 subgroup, and bytes $D_{8734}$ to $D_{17,647}$ in a second track (track B) of the G3 subgroup. The subgroups, having had headers appended to them by header processor 804 are then 8-10 block encoded by 8-10 block encoder 808, before writing to the tape data storage medium 809 in a physical layout as illustrated with reference to Fig. 6 herein, where data tracks are written across the width of the magnetic type.

In the read channel, the data stored on the tape data storage medium 809 is read by a magnetic head and amplified and equalized before being passed into a sequence detector. The detected signal is input into a 10-8 block decoder, 810 and then passed to a header processor 812, in which the headers of each data block are read for identification of data blocks. C1, C2 correction is applied in a G4 subgroup correction processor 812. G1, G2 and G3 sub groups are processed in corresponding G1, G2, G3 sub group processors 816, 815, 814 respectively. Track check sum values are recovered by a track check sum retriever 813. Check sums are applied at two stages. Firstly, after C1, C2 correction 813, and secondly, after C3 correction 817. A basic group is output after error correction and detection at output 818.

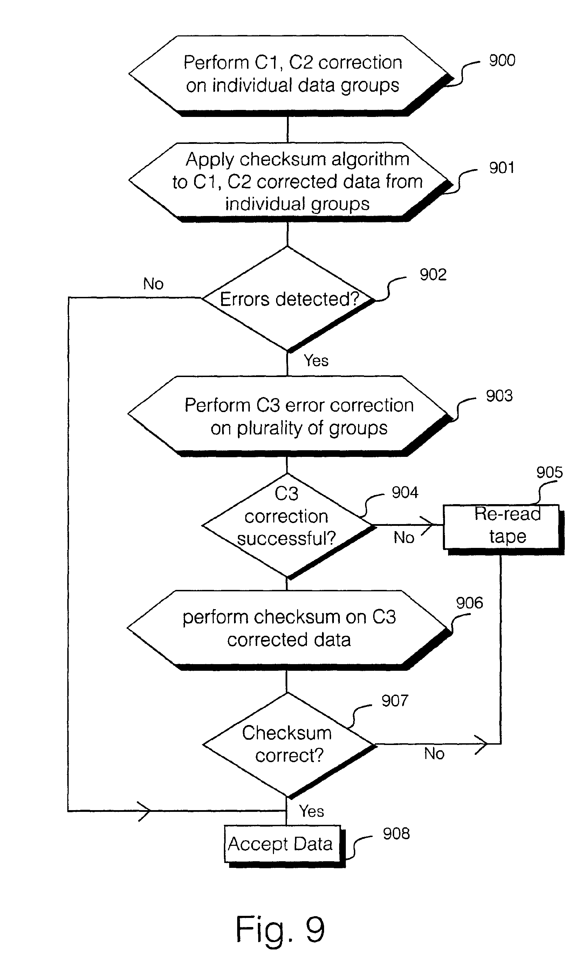

Referring to Fig. 9 herein, there is illustrated schematically a specific method according to the best mode herein for applying error detection by means of a check sum algorithm during signal processing stages in a read channel of a digital data storage device. In step 900, C1 and C2 correction is performed on individual data groups read from the tape. In step 901, a check sum algorithm is applied to the C1, C2 corrected data of the individual data groups. If no errors are detected by the check sum algorithm in step 902, then the data is accepted in step 908. However, if errors are detected by the check sum algorithm in step 902, then in step 903 C3 error correction is performed on a plurality of groups. C3 error correction attempts to correct defects in individual data groups from redundancy encoded data present in other data groups. The C3 error correction may be able to correct errors in individual data groups. However, if the C3 error correction is unable to make such correction, then the tape is re-read in step 905. The decision on whether to re-read the tape is carried out within the C3 correction algorithm. If C3 correction is successfully completed in step 904, then in step 906, the check sum algorithm is again applied to the C3 corrected data. If the calculated check sum coincides with the pre-stored check sum read from the tape in step 907, then the data is accepted in step 908. However, if the check sum is not correct, then the data is re-read from the tape in step 905.

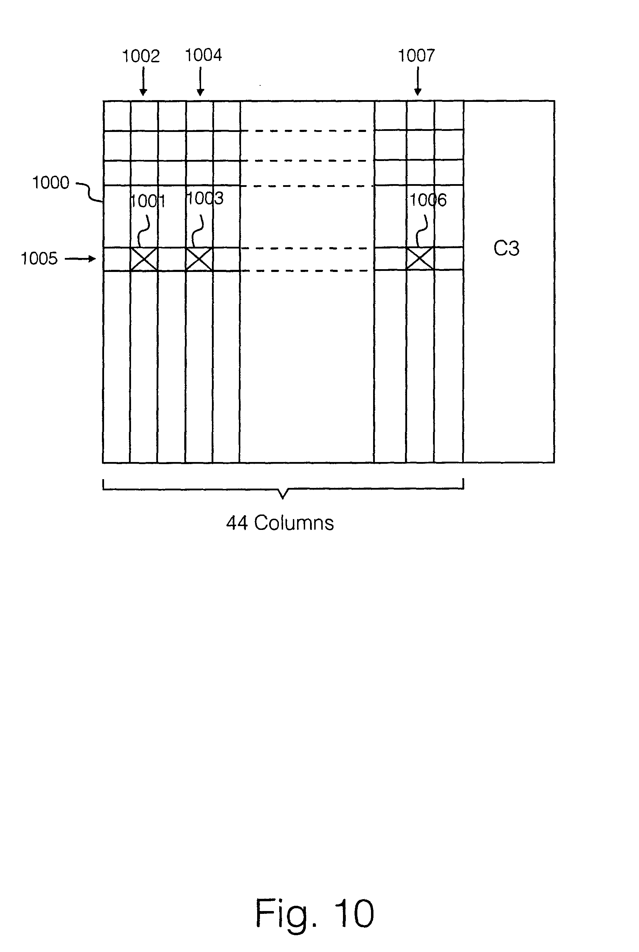

Referring to Fig. 10 of the accompanying drawings, there is illustrated schematically a frame of data 1000 containing C3 error correction. The frame comprises a 2-dimensional array having 44 columns, each comprising a C1, C2 corrected data group. C3 coding exists as a plurality of additional columns in the frame. The C3 correction is applied by reading across rows of the data frame. The plurality of columns (data groups) may contain C1, C2 mis-corrects. The C3 correction both detects and corrects residual errors in a frame. Where the number of errors is greater than can be corrected by the C3 correction, the C3 correction directs re-reading of data from the tape.

C1, C2 correction can either leave original errors uncorrected, or can correct those errors, or can introduce further errors by a process of mis-correction.

There may occur a situation where a C1, C2 uncorrected error 1001 occurs in a first column 1002 corresponding to a first data group, and a second C1, C2 uncorrected error 1003 occurs in a second column 1004 corresponding to a second data group. Because the first and second C1, C2 uncorrected errors 1001, 1003 appear on a same row 1005 of the data frame, the C3 correction, which operates across the row, may mis-correct the row due to the high occurrence of errors after C1, C2 correction. Mis-correction of the row by the C3 correction may result in more errors being introduced. Such mis-corrections are very rare, but can occur.

Therefore, if a further error 1006 is introduced into a new column 1007, by C3 mis-correction, then there is an advantage in detecting this further error. This further error is always detected by operation of a check sum algorithm according to the best mode herein.

A check sum algorithm is implemented on the user data content (including C1, C2 correction) after each data frame 1000. After C3 correction, the same check sum calculation is applied across each column of the data frame in order to detect any mis-corrections which may have occurred by the C3 correction. Additionally, the second check sum as described herein has the property that if 2 errors are introduced by C3 mis-correction in a same column (that is to say in the same data group) or if two such errors occur in that column by any other process, then the check sum will detect these two errors in any one column with a probability of failure of 1 in 65,536.

Therefore, two common occurrences of residual errors still being extant in the data frame will almost always be detected by check sum detection after C3 correction, in which case the data can be re-read from the tape.

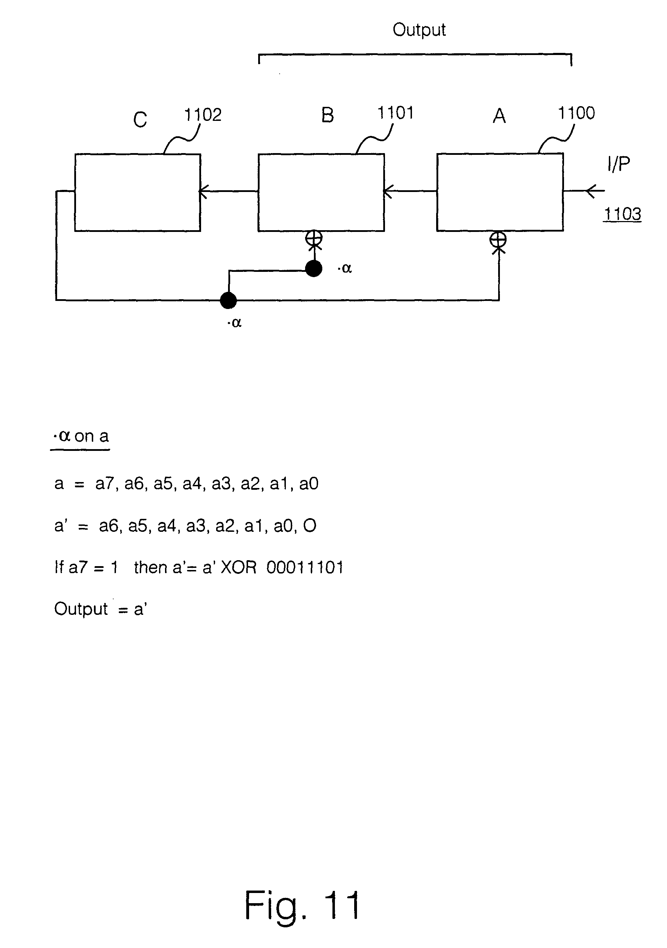

Referring to Fig. 11 herein, there is illustrated schematically a hardware equivalent for performing a check sum calculation process on each column of a data frame 1000. It will be appreciated by those skilled in the art that the hardware of Fig. 11 may be replaced by equivalent hardware implementations to perform a same function, or may be replaced by a data processor and/or computer plus computer program for carrying out a same function. In the best mode herein, the function represented by the hardware of Fig. 11 is implemented as an application specific integrated circuit (ASIC).

The check sum calculator of Fig. 11 gives a means of implementing the polynomial remaindering process previously mentioned herein. It comprises a shift register having first, second and third locations 1100, 1101, 1102, denoted A, B, C respectively each of length one byte. Data 1103 corresponding to each column of data frame 1000 is input into the register 1 byte at a time. The register is clocked 1 byte at a time for a data input comprising a byte stream $D_0$, $D_1$, $D_2$... The output is taken as a 16 bit value formed from bytes B and A after all the data bytes have been input into the register.

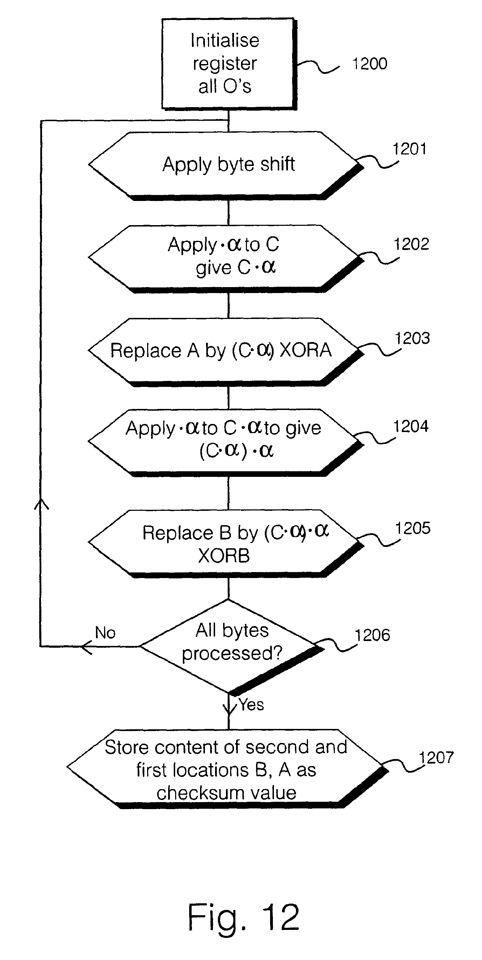

Although, in Fig. 12 a 3 byte shift register implementation for performing the polynomial remaindering process is shown, a hardware shift register implementation, in the form of an application specific integrated circuit, can be produced where a two byte shift register is used.

Referring to Fig. 12, there is illustrated step wise operation of the shift register of Fig. 11 for processing a byte data stream corresponding to a single column of user data of data frame 1000. A single column of data comprises user data bytes $D_0$, $D_1$, $D_2$...$D_{11,645}$. For each column, prior to entering the column of data bytes the register is initialized so that all locations are set initially to value 0 in step 1200. In step 1201, a byte shift is applied to the register so that a first byte $D_0$ enters the first location 1100. The remaining locations 1101, 1102 remain at value 0. A function $\cdot\alpha$ is applied to the output of the first location in step 1202 and in step 1203 there is applied an exclusive OR (XOR) of that value with the value stored in first location 1100. In step 1204, the function $\cdot\alpha$ is applied to the result of the function $\cdot\alpha$ on the content C of first location 1102. The resultant value is combined by an exclusive OR function with the content B of the second location 1101 in step 1205. In step 1206, it is checked whether all bytes of the column have been processed. If all bytes have not been processed, then the shift register is clocked to enter the next byte of the column sequence $D_1$ into the first location 1100. The content of first location 1100, that is the function $\cdot\alpha$ on A is shifted into the second location 1101. The previous content of the second location 1101, that is $\cdot\alpha$ applied to $\cdot\alpha$ on the content of content C of third location 1102 is shifted into the third location 1102 in step 1101. Steps 1102-1205 repeat. All bytes of the column sequence up to $D_{11,645}$ are processed in this manner. The output of the device after this process is the content of the second and third locations B, A of the shift register (in step 1207).

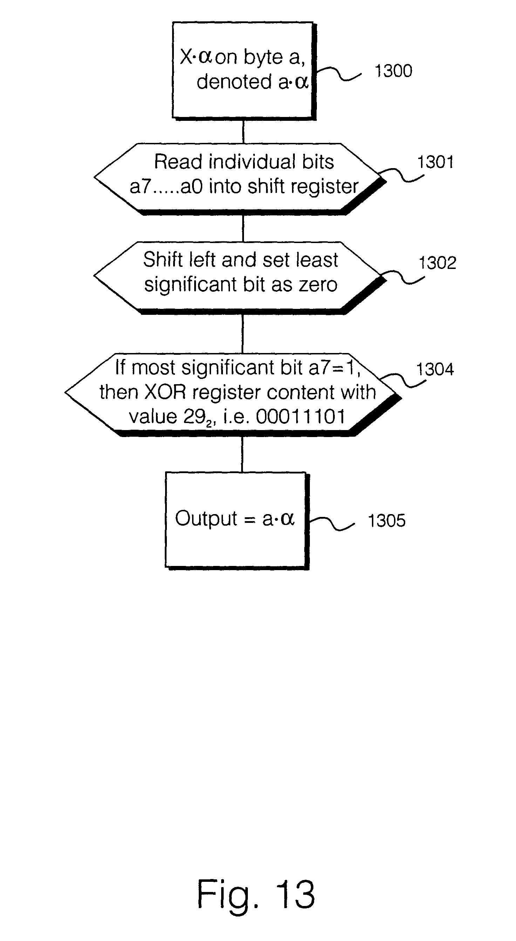

Referring to Fig. 13 herein, there is illustrated operation of the function $\cdot\alpha$ on a single byte $a\cdot\alpha$ To obtain the function $\cdot\alpha$ on a 1300, denoted $a\cdot\alpha$ in step 1401 the byte a is read as a plurality of 8 individual bits $a_7$, $a_6$, $a_5$, $a_4$, $a_3$, $a_2$, $a_1$, $a_0$ into a shift register. In step 1302, the shift register is shifted left, and the least significant bit of a shift register is set at 0, giving $a_6$, $a_5$, $a_4$, $a_3$, $a_2$, $a_1$, $a_0$. If the most significant bit $a_7$ had a value 1, then the left shifted content of the shift register is XOR'ed with a second mask function equivalent to binary value 29, i. e. 0,0,0,1,1,1,0,1 in step 1303. The result of the operations is an output a·α in step 1304.

The mask function binary 29 in the ·α sub function is selected due to its close relationship with the error correction codes C1, C2 and C3. This choice of the second mask value in combination with the choice of polynomial $X^2 + X\alpha^2 + \alpha$ means that the check sum has several properties as follows:

- The check sum detects all C1, C2 mis-corrects, where the error pattern is restricted to lie on user data bytes and the error pattern has the minimum possible Hamming weight.
- As a consequence of the shift register arrangement of Fig. 11, in combination with the mask value, gives the property that one or two new errors introduced into a C1, C2 data group can almost always be detected, for example if they are introduced by C3 miscorrection.
- The shift register structure corresponds to a polynomial:

$$X^2 + \alpha^2 X + \alpha$$

  which is a degree 2 polynomial having co-efficients 1, $\alpha^2$ and $\alpha$, where $\alpha$ is an algebraic expression which lends the polynomial the property of primitivity over $GF(2^8)$. This means that the check sum has the power to detect almost all errors in one or two positions in each column of the frame of Fig. 10. The expression is efficiently implemented in hardware, because the operation ·α only needs to be carried out in a small number of places. The powers of $\alpha$ used are relatively small, and yet the polynomial still has the property of primitivity and the power to detect C3 mis-corrects.

Roots of the cyclical redundancy check polynomial used in the polynomial remaindering process are not roots of a generator polynomial of the Reed-Solomon error correcting code.

The maximum error detecting capability is extracted when the roots of the polynomial used in the remaindering process are all different from the roots of the generator polynomial of the Reed-Solomon code. However, whilst not optimal, significant error detecting capability increase can be obtained when just one of the roots of the CRC polynomial is different from all the roots of the generator polynomial of the Reed-Solomon code.

In the present implementation, the polynomial remaindering process is applied to the corrected data, processing one byte at a time. The C1, C2 corrected and C3 corrected user data is clocked through the shift register in a byte wise manner, that is to say one byte at a time. This is significantly different from prior art algorithms which shift data though a register one bit at a time in a bit wise fashion.

In the prior art DDS-4 format, the check sum was restricted to being calculated on user data bytes only. Other bytes which are recorded on the tape, for example parity bytes and headers, do not have the check sum applied in DDS-4. In the best mode herein, the check sum is applied to the user data bytes only, and is not applied to the parity bytes, and other header information required from the tape by the read channel. For C1, C2 mis-correction errors occurring in the user data bytes, then a common form of mis-correction, which is a mis-correction of minimum possible Hamming weight , will always be detected with a probability of 1 by the check sum method according to the best mode herein.

Approximately 19% of this common C1, C2 mis-correction error occurs in the user data. Of this 19%, 100% of that common mis-correction is detected by the check sum according to the best mode herein. Of the remaining C1, C2 mis-correction errors, these errors may be spread between the parity and header bytes written to the physical tracks, and the user data. For this remaining set of C1, C2 mis-correction errors, the check sum method according to the best mode herein fails to detect those mis-corrections with a probability of only 1 in 65,536 (1 in $2^{16}$). Therefore, for 65,535 out of 65,536 times, the remaining mis-correction errors are detected.

**Claims**

1. A method of reading data coded with a Reed-Solomon error correcting code, said method **characterized by** comprising the steps of:

   reading (600) said data; and

   performing a check sum calculation (602) on said data;

   wherein said check sum calculation (602) includes applying a byte based polynomial remaindering process to the bytes of said data, the polynomial used in said polynomial remaindering process being primitive over $GF(2^8)$; and

   the roots of the polynomial used in said polynomial remaindering process are different to the roots of a generator polynomial of said Reed-Solomon error correcting code.

2. The method as claimed in claim 1, wherein:

   said step of reading said data comprises reading (800) a group of said coded data; and

   further comprising the step of performing an error correction (801, 807, 812) on said coded data group to produce a corrected data group.

**3.** The method as claimed in claim 2, wherein;

said step of performing a check sum calculation on said data comprises performing a check sum calculation on said error corrected data group; and
said polynomial remaindering process in applied to bytes of said corrected data group.

**4.** The method as claimed in claim 1, comprising the steps of:

reading a plurality of groups of coded data;

performing error correction on each of said individual data groups of coded data to produce a plurality of corrected data groups;

performing a first check sum calculation (901) on each of said plurality of corrected data groups;

performing further error correction (903) on said plurality of corrected data groups;

performing the same check sum calculations (906) as previously performed on the individual corrected data groups; and

at least one of said check sum calculations includes applying a byte based polynomial remaindering process to the bytes of said corrected data groups.

**5.** The method as claimed in any one of the preceding claims, wherein said polynomial is $X^2 + X\alpha^2 + \alpha$, where $\alpha$ is the primitive element $GF(2^8)$ used in the process of defining redundancy coding.

**6.** The method as claimed in any one of the preceding claims, wherein said polynomial remaindering process is carried out using a sub function which contains a mask function which is the same as a mask function used in defining redundancy coding for a data group or groups and wherein the said data group or groups are redundancy coded using a Reed- Solomon code over $GF(2^8)$.

**7.** The method as claimed in claim 6, wherein said sub function for a byte of data is determined by:

inputting said byte of data into an 8 bit shift register(1201);

reading a most significant bit of said byte;

shifting said byte of data by one bit to obtain a shifted byte value (1201);

setting a least significant bit of said shifted byte to value 0 (1302); and

if said most significant bit has a value 1, performing (1304) an exclusive OR of said shifted byte with a binary value 29.

**8.** The method as claimed in any one of the preceding claims, wherein the polynomial used in said polynomial remaindering process is primitive over $GF(2^8)$, the Galois field containing 256 elements.

**9.** The method as claimed in any one of the preceding claims, wherein said check sum calculations operate with a probability of failing to detect a random mis-correct error in one or more data groups of 1 in $2^{16}$.

**10.** The method as claimed in any one of the preceding claims, wherein for mis-correction errors of minimum Hamming weight occurring in user data the probability of detecting such mis-correction errors is substantially 1.

**11.** The method as claimed in any one of the preceding claims, having a probability of failing to detect mis-correction errors of substantially 1 in $2^{16}$.

**12.** A digital data storage device capable of reading a magnetic tape data storage medium comprising a plurality of data tracks written across a width of said tape in a direction transverse to a main length of said tape, said data storage device comprising a read channel capable of implementing a method as described in any one of the preceding claims.

**13.** An apparatus for reading data, said apparatus **characterized by** comprising:

a reader (810) for reading data; and

a check sum calculator (813) for performing a check sum calculation on the data,

wherein said check sum calculation includes applying a byte based polynomial remaindering process to the bytes of said data, wherein a polynomial used in said polynomial remaindering process is primitive over $GF(2^8)$; and

the roots of a polynomial used in said polynomial remaindering process are different to the roots of a generator polynomial of a Reed-Solomon error correcting code.

**14.** The apparatus as claimed in claim 13, further comprising:

an error corrector (812) for performing error correction on said data; and wherein

said reader operates to read a group of redundancy coded data;

said error corrector operates to produce corrected data; and

said polynomial remaindering process is applied to bytes of said corrected data group.

15. The apparatus as claimed in claim 13 or 14, comprising:

a reader (810) for reading a plurality of groups of coded data;

a first error corrector (812) for performing error correction on individual said data groups of coded data to produce a plurality of corrected data groups;

a first check sum calculator (813) for performing a first check sum calculation on each of said plurality of corrected data groups;

a second error corrector (817) for performing further error correction on the plurality of error corrected data groups;

a second check sum calculator (813) for performing the same check sum calculations as previously performed on the individual corrected data groups;

wherein at least one of said check sum calculations includes applying said byte based polynomial remaindering process to the bytes of said corrected data groups.

16. The apparatus as claimed in any one of claims 13 to 15, wherein said polynomial is $X^2 + X\alpha^2 + \alpha$, where $\alpha$ is the primitive element of $GF(2^8)$ used in the process of defining the redundancy coding for individual data groups.

17. The apparatus as claimed in any one of claims 13 to 16, wherein said polynomial remaindering process is carried out using a sub function which contains a mask function which is the same as a mask used in function defining redundancy coding for a data group or groups and wherein said data group or groups are redundancy coded using a Reed-Solomon code over $GF(2^8)$.

18. The apparatus as claimed in any one of claims 13 to 17, wherein said polynomial remaindering process is carried out using a sub function which contains a mask function which is the same as a mask used in defining redundancy coding for a data group or groups and wherein the said data group or groups are redundancy coded using a Reed-Solomon code over $GF(2^8)$, wherein the said sub function is determined by:

inputting said byte of data into an 8 bit shift register;

reading a most significant bit of said byte;

shifting said byte of data by one bit to obtain a shifted byte value;

setting a least significant bit of said shifted byte to value 0; and

if said most significant bit has a value 1, performing an exclusive OR of said shifted byte with a binary value 29.

19. The apparatus as claimed in any one of claims 13 to 18, wherein said check sum calculations operate with a probability of failing to detect a random mis-correct error in one or more data groups of 1 in $2^{16}$.

20. The apparatus as claimed in any one of claims 13 to 19, wherein for mis-correction errors of minimum Hamming weight occurring in user data the probability of detecting such mis-correction errors is substantially 1.

21. The apparatus as claimed in any one of claims 13 to 20, operating with a probability of failing to detect mis-correction errors of substantially 1 in $2^{16}$.

# Fig. 1
## (Prior Art)

# Fig. 3
## (Prior Art)

Fig. 2
(Prior Art)

Fig. 4
(Prior Art)

Fig. 5
(Prior Art)

600

C1
error
correction

601

C2
error
correction

602

Check
sum
calculation

603

C3
error
correction

Fig. 6
(Prior Art)

$D_0, D_1, D_2, D_3, \ldots\ldots\ldots D_n$

$0 \leqslant D_i \leqslant 255$

DDS-4 Checksum

$$= \text{16 least significant bits of } \sum_{i=0}^{n} D_i$$

# Fig. 7
# (Prior Art)

Fig. 8

Fig. 9

Fig. 10

Output

C   1102     B   1101     A   1100

I/P

1103

·α

·α

·α on a

a = a7, a6, a5, a4, a3, a2, a1, a0

a' = a6, a5, a4, a3, a2, a1, a0, O

If a7 = 1   then a'= a' XOR   00011101

Output = a'

# Fig. 11

Initialise
register
all O's
~ 1200

Apply byte shift
~ 1201

Apply $\cdot\alpha$ to C
give $C\cdot\alpha$
~ 1202

Replace A by $(C\cdot\alpha)$ XORA
~ 1203

Apply $\cdot\alpha$ to $C\cdot\alpha$ to give
$(C\cdot\alpha)\cdot\alpha$
~ 1204

Replace B by $(C\cdot\alpha)\cdot\alpha$
XORB
~ 1205

All bytes
processed?
~ 1206

No

Yes

Store content of second and
first locations B, A as
checksum value
~ 1207

# Fig. 12

$X \cdot \alpha$ on byte a, denoted $a \cdot \alpha$ — 1300

Read individual bits a7.....a0 into shift register — 1301

Shift left and set least significant bit as zero — 1302

If most significant bit a7=1, then XOR register content with value $29_2$, i.e. 00011101 — 1304

Output = $a \cdot \alpha$ — 1305

Fig. 13

**European Patent Office**

## EUROPEAN SEARCH REPORT

Application Number

EP 01 30 3265

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | EP 0 291 167 A (MATSUSHITA ELECTRIC IND CO LTD) 17 November 1988 (1988-11-17) * page 4, line 43 - page 7, line 47; figures 2,3 * --- | 1-4,13, 14 | H03M13/09 H03M13/00 H03M13/15 G11B20/18 |
| A | US 5 465 260 A (ZOOK CHRISTOPHER P) 7 November 1995 (1995-11-07) * column 2, line 57 - column 3, line 66 * --- | 4,13,14 | |
| A | EP 0 497 593 A (QUANTUM CORP) 5 August 1992 (1992-08-05) --- | | |
| A | US 4 151 510 A (CIRCELLO JOSEPH C ET AL) 24 April 1979 (1979-04-24) --- | | |
| A | EP 0 407 101 A (DIGITAL EQUIPMENT CORP) 9 January 1991 (1991-01-09) ----- | | |

| | TECHNICAL FIELDS SEARCHED (Int.Cl.7) |
|---|---|
| | H03M G11B |

The present search report has been drawn up for all claims

| Place of search | Date of completion of the search | Examiner |
|---|---|---|
| THE HAGUE | 2 August 2001 | Devergranne, C |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

EP 1 146 651 A1

## ANNEX TO THE EUROPEAN SEARCH REPORT
## ON EUROPEAN PATENT APPLICATION NO.                    EP 01 30 3265

This annex lists the patent family members relating to the patent documents cited in the above-mentioned European search report.
The members are as contained in the European Patent Office EDP file on
The European Patent Office is in no way liable for these particulars which are merely given for the purpose of information.

02-08-2001

| Patent document cited in search report | | Publication date | Patent family member(s) | | Publication date |
|---|---|---|---|---|---|
| EP 0291167 | A | 17-11-1988 | JP | 63255876 A | 24-10-1988 |
| | | | JP | 63257966 A | 25-10-1988 |
| | | | DE | 3887200 D | 03-03-1994 |
| | | | DE | 3887200 T | 05-05-1994 |
| | | | US | 4949342 A | 14-08-1990 |
| US 5465260 | A | 07-11-1995 | EP | 0729674 A | 04-09-1996 |
| | | | JP | 9507118 T | 15-07-1997 |
| | | | SG | 43012 A | 17-10-1997 |
| | | | WO | 9512921 A | 11-05-1995 |
| | | | US | 5671237 A | 23-09-1997 |
| | | | US | 5602857 A | 11-02-1997 |
| | | | US | 5600662 A | 04-02-1997 |
| | | | US | 5629949 A | 13-05-1997 |
| | | | US | 5724368 A | 03-03-1998 |
| EP 0497593 | A | 05-08-1992 | US | 5241546 A | 31-08-1993 |
| | | | DE | 69229753 D | 16-09-1999 |
| | | | DE | 69229753 T | 02-03-2000 |
| | | | IE | 920104 A | 12-08-1992 |
| | | | JP | 2724934 B | 09-03-1998 |
| | | | JP | 5347075 A | 27-12-1993 |
| | | | KR | 9509384 B | 21-08-1995 |
| | | | US | 5517631 A | 14-05-1996 |
| | | | US | 5255136 A | 19-10-1993 |
| US 4151510 | A | 24-04-1979 | AU | 528546 B | 05-05-1983 |
| | | | AU | 4647379 A | 01-11-1979 |
| | | | CA | 1123105 A | 04-05-1982 |
| | | | DE | 2914515 A | 08-11-1979 |
| | | | FR | 2424588 A | 23-11-1979 |
| | | | JP | 1503864 C | 28-06-1989 |
| | | | JP | 54148406 A | 20-11-1979 |
| | | | JP | 63046615 B | 16-09-1988 |
| EP 0407101 | A | 09-01-1991 | US | 5136592 A | 04-08-1992 |
| | | | CA | 2016847 A | 28-12-1990 |
| | | | JP | 3136524 A | 11-06-1991 |

EPO FORM P0459

For more details about this annex : see Official Journal of the European Patent Office, No. 12/82

23